(19) Europäisches Patentamt
European Patent Office
Office européen des brevets

(11) **EP 3 077 791 B1**

(12) **EUROPEAN PATENT SPECIFICATION**

(45) Date of publication and mention of the grant of the patent:
**26.05.2021 Bulletin 2021/21**

(21) Application number: **14823915.5**

(22) Date of filing: **02.12.2014**

(51) Int Cl.:
*H01M 8/18* (2006.01)  *H01M 8/04537* (2016.01)
*G01N 21/31* (2006.01)  *G01R 31/367* (2019.01)
*H01M 8/0444* (2016.01)  *G01N 21/17* (2006.01)

(86) International application number:
**PCT/EP2014/076266**

(87) International publication number:
**WO 2015/082475 (11.06.2015 Gazette 2015/23)**

(54) **METHOD FOR DETERMINING THE STATE OF CHARGE OF A VANADIUM REDOX FLOW BATTERY**

VERFAHREN ZUR ERMITTLUNG DES LADEZUSTANDES EINER VANADIUM-REDOX-DURCHFLUSSBATTERIE

PROCÉDÉ POUR DÉTERMINER L'ÉTAT DE CHARGE D'UNE BATTERIE À FLUX REDOX AU VANADIUM

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.12.2013 EP 13195315**

(43) Date of publication of application:
**12.10.2016 Bulletin 2016/41**

(73) Proprietor: **University of Limerick Limerick (IE)**

(72) Inventors:
• **BUCKLEY, Denis Noel**
  **Limerick (IE)**
• **GAO, Xin**
  **Shanghai (CN)**
• **LYNCH, Robert Patrick**
  **Clare (IE)**
• **LEAHY, Martin J.**
  **Limerick (IE)**
• **BOURKE, Andrea**
  **Limerick (IE)**
• **FLYNN, Grace**
  **Kerry (IE)**

(74) Representative: **Purdylucey Intellectual Property 6-7 Harcourt Terrace D02 FH73 Dublin 2 (IE)**

(56) References cited:
**CN-B- 102 539 362    CN-B- 102 621 085**

• **ZHIJIANG TANG ET AL: "Monitoring the State of Charge of Operating Vanadium Redox Flow Batteries", ECS TRANSACTIONS, vol. 41, no. 23, 1 January 2012 (2012-01-01), pages 1-9, XP055099490, ISSN: 1938-5862, DOI: 10.1149/1.3697449**

## Description

### Field

The invention relates to a method for determining the state of charge of a vanadium redox flow battery.

### Background

During the charging-discharging process of a vanadium redox flow battery (VRFB), the state of charge (SoC) of the battery is dependent on the amount of $V''$ on the negative side of the battery and the amount of $V^V$ on the positive side of the cell. One reason for the necessity to measure the amount of both of these species is because hydrogen evolution and other processes occur in VRFBs, which result in the negative and positive half-cells differing in the amount of vanadium in their respective charged state. Similarly, the transfer of vanadium species through membranes that separate the two halves of each cell of the battery often results over time in significant changes in the total amount of vanadium present on each side of the battery. Therefore, it is necessary to know the mixture ratio and the total amount of vanadium, *i.e.* it is necessary to know the amount of vanadium in the charged state, of both the positive and negative half-cell so as to be able to determine the remaining charge of the battery. Furthermore, knowledge of the two mixture ratios of the vanadium species can be used to determine when there is a danger of overcharging allowing greater control of the system and prevention of damage to electrodes prior to it occurring.

There are several known ways of measuring the $V^{II}/V^{III}$ and $V^{IV}/V^V$ mixture ratios. For instance, it is known that the Nernst equation defines the relationship between the mixture ratio and the potential. This equation is:

$$E = E^0 + \frac{RT}{nF} log \left( \frac{[V^{II}][V^V]}{[V^{III}][V^{IV}]} \right)$$

where E° is the equilibrium potential *(i.e.* the potential is the summation of the formal potential of $V^{II}/V^{III}$ and the formal potential of $V^{IV}/V^V$) in volts (V), R is the universal constant (8.314 J mol$^{-1}$ K$^{-1}$), T is the temperature in Kelvin (K), n is the electron-transfer number, F is Faraday's constant (96485 C mol$^{-1}$), $V^{II}/V^{III}$ is the mixture ratio for the anolyte, and $V^V/V^{IV}$ is the mixture ratio for the catholyte. It follows that, as long as the mixture ratios of the two half cells are equal *(i.e.* as long as $V^{II}/V^{III}$ is equal to $V^V/V^{IV}$) the mixture ratios and therefore the SoC of the battery can be determined. Indeed, the conventional and most used method for determining the SoC of a VRFB is by measuring the open-circuit voltage of the battery. One such example of this method is set out in US Patent Publication No. 2012/022535 in the name of Christensen, which describes a technique that relies on the open-circuit potential of a battery to measure an initial SoC, and then monitors the flow of current while the circuit is closed so as to track changes in the SoC.

One problem with measuring the SoC of a battery by means of its open-circuit voltage is that since the current efficiencies of the two half cells are not the same, it follows that the mixture ratios of the two half cells are rarely the same. An alternative method that is widely used in research to determine the SoC of a VRFB is through the use of reference electrodes placed in the two half cells. Another known method for calculating the SoC is to measure the conductivity of the electrolyte, as disclosed by PCT Patent Publication Number WO 90/03666 in the name of Skyllas-Kazacos. However, both of these techniques also require extra electrodes to be placed within the cell, and can therefore interfere with the operation of the cell.

All of these known methods of calculating the SoC of a VRFB have drawbacks. Firstly, it is not simple to measure the SoC of a half-cell, since small offsets and drifts in the potentials of the electrodes can be equivalent to the change in potential for a significant change in mixture ratio, especially for mixture ratios close to 50%. Furthermore, due to the nature of the electrolyte, the solution in reference electrodes may be easily contaminated. In addition, as these methods are electrochemical, they do not provide an independent reading, in that they will vary in a similar manner to the cell output regardless of whether the variation is due to an actual change in mixture ratio or the presence of impurities, changes in surface states or other issues that alter the behaviour of the electrodes. Furthermore, these methods can interfere with the operation of the battery: *e.g.* they may increase leakage currents if not engineered into the battery with due care.

Spectroscopy can be used to accurately measure the concentration of species in solution by measuring the absorbance of the solution at different wavelengths. Often such methods are facile since the absorbance at a wavelength and the concentration of a species will vary proportionally. US Patent No. 7,855,005 in the name of Sahu and PCT Patent Publication Number WO 90/03666 in the name of Skyllas-Kazacos describe methods for determining the SoC of different flow batteries using the linear relationship between absorbance and mixture ratio at specific wavelengths.

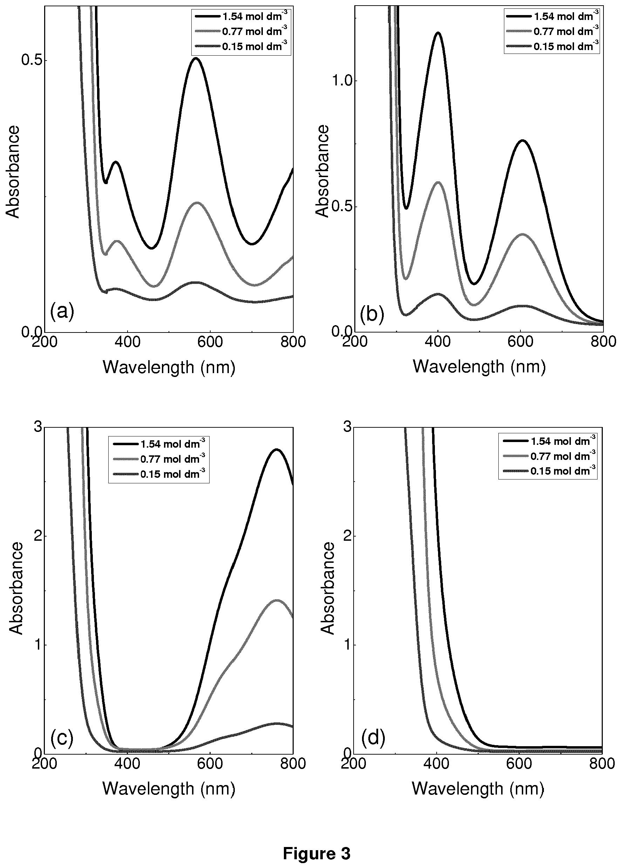

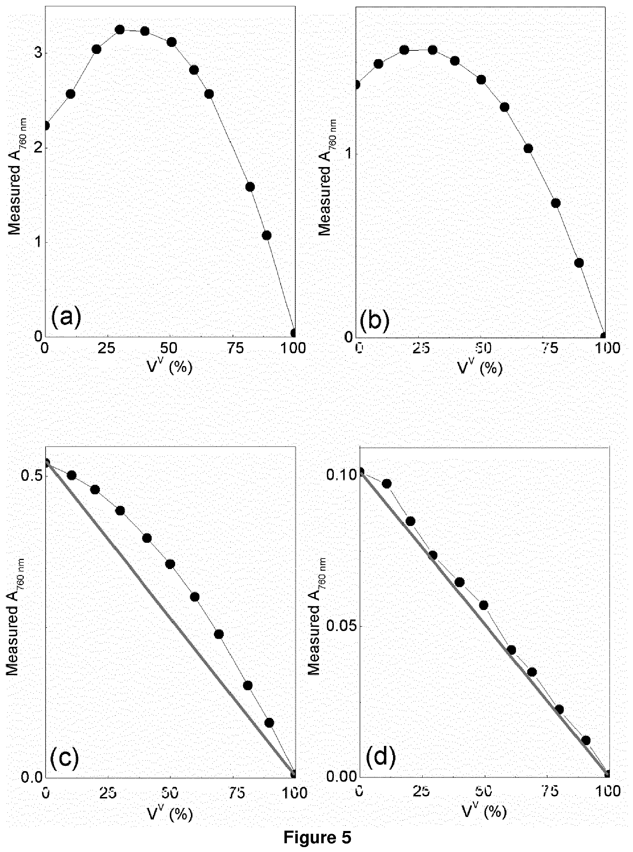

Spectroscopy can also be used to monitor the vanadium mixture ratio of species as long as the absorbance is proportional to the concentration of each species. In this regard, it has been found that the mixture ratio of the negative electrolyte or the amount of V" (*i.e.* in $V^{II}/V^{III}$ mixtures) can be determined using the linear response of absorbance to mixture ratio at several wavelengths. (PCT Patent Number WO 90/03666 in the name of Skyllas-Kazacos). The absorbance of a vanadium solution of only $V^{IV}$ or $V^{V}$ varies linearly with vanadium concentration. However, despite there being wavelengths where the absorbance due to $V^{IV}$ is significantly greater than the absorbance due to $V^{V}$ and *vice versa* (as is shown in Figure 3), high concentration mixtures of $V^{IV}$ and $V^{V}$ solution result in non-linear variations of absorbance with respect to the percentage of $V^{V}$ (or $V^{IV}$) for any particular wavelength, as is shown in Figure 5a. Dilution of the electrolyte reduces this non-linear behaviour towards that of a linear behaviour between absorbance and mixture ratio, as is shown in Figure 5d Thus, at the vanadium concentrations used, a linear relationship between mixture ratio and absorbance does not exist for the positive electrolyte of VRFBs due to the formation of a complex between $V^{IV}$ and $V^{V}$ species.

Chinese Patent Publication No, CN 102 539 362 describes the dilution of solutions to gain solutions that are of low enough concentration that the effect of complex formation is removed, in order that the solutions can be analyzed by spectroscopy in a conventional manner. Zhijiang Tang et al.,(ECS Transactions, vol. 41, no. 23, 1 January 2012, pages 1-9), describes a method to assess the state of charge of vanadium redox flow batteries during operation using UV-Vis spectrometry and full cell OCV measurements. The non linear relationship of the absorbance with the SoC renders the assessment of the SoC of the positive electrolyte less accurate.

To overcome this lack of a linear relationship between absorbance and mixture ratio for the positive electrolyte in vanadium solutions, it is known to use a set of calibration spectra for comparing against spectra taken from operating VRFBs (L. Lie, et al., J. Appl. Electrochem. 42, 1025 (2012)). However, it will be appreciated that this requires a set of calibration spectra for the specific solution, as well as a large amount of computational processing power to compare the operational spectrum to the calibration spectra. Furthermore, due to changes in the overall vanadium concentration during operation of a VRFB - caused by the diffusion of species across the proton exchange membrane and volume change due to transfer of water - the calibrated spectra become less valid with each charge-discharge cycle of the battery.

Therefore, there exists a need to provide an improved method for determining the mixture ratio of $V^{IV}$ and $V^{V}$ solutions from absorption spectra.

### Summary of the Invention

According to the invention there is provided, as set out in the appended claims, a method for determining the state of charge, SoC, of a vanadium flow battery positive electrolyte comprising a solution of $V^{IV}$ and/or $V^{V}$, the method comprising the steps of: determining the absorbance of the solution at at least one wavelength; and calculating the concentration of $V^{IV}$ and/or $V^{V}$ in the vanadium flow battery positive electrolyte based on the absorbance.

In one embodiment, the overall vanadium concentration in the vanadium flow battery positive electrolyte is known and where a non-proportional relationship exists between the vanadium species concentration and absorbance due to the presence of complexes between $V^{IV}$ and $V^{V}$, wherein the step of calculating the concentration of $V^{IV}$ and/or $V^{V}$ vanadium flow battery positive electrolyte based on the absorbance comprises the steps of:

comparing the absorbance against a look-up graph of absorbance versus fraction of $V^{V}$ for at least one wavelength and for the same overall vanadium concentration; and
estimating the fraction of $V^{IV}$ and/or $V^{V}$ in the solution from the comparison.

In one embodiment the method further comprises:

determining the absorbance of the solution of the vanadium flow battery positive electrolyte at at least one alternative wavelength;
comparing the absorbance against a look-up graph of absorbance versus fraction of $V^{V}$ for the at least one alternative wavelength and for the same overall vanadium concentration; and
estimating the fraction of $V^{IV}$ and/or $V^{V}$ in the solution from the comparison performed at the at least one wavelength and the comparison performed at the at least one alternative wavelength.

In one embodiment the method further comprises estimating the fraction of $V^{IV}$ and/or $V^{V}$ in the solution from the comparison performed at the at least one wavelength and based on one or more of: positive state of charge, SoC, negative SoC, cell voltage or the change in absorbance when charging or discharging of the vanadium flow battery positive electrolyte.

In one embodiment the look-up graph of absorbance versus fraction of $V^{V}$ for a given wavelength is constructed by the steps of:

determining for the given wavelength the absorbance of a $V^{IV}$ solution of a known concentration; and

determining for the given wavelength the absorbance of a calibration sample of the vanadium flow battery positive electrolyte of a known mixture ratio and a known vanadium concentration.

In one embodiment two calibration samples of vanadium flow battery positive electrolytes of known vanadium concentration and mixture ratio are used for the construction of the look-up graph.

In one embodiment a solution whose $V^{IV}/V^V$ mixture ratio can be changed in a controlled manner, and wherein the calibration comprises changing the mixture ratio and comparing the change in mixture ratio to the absorbance of the solution.

In one embodiment, the $V^{IV}/V^V$ mixture ratio is changed in a controlled manner by passing current through the electrode of a half-cell.

In one embodiment the overall vanadium concentration is known and where a non-proportional relationship exists between vanadium species concentration and absorbance due to the presence of complexes between $V^{IV}$ and $V^V$, wherein the step of calculating the concentration of $V^{IV}$ and/or $V^V$ in the vanadium flow battery positive electrolyte based on the absorbance comprises the steps of:

> determining the ratio of excess absorbance for a pair of specific wavelengths; and
> estimating the concentration of $V^{IV}$ and/or $V^V$ by solving simultaneous equations based on the determined ratio of excess absorbance for the pair of specific wavelengths.

In one embodiment the overall vanadium concentration is not known for the vanadium flow battery positive electrolyte and, wherein the total concentration of vanadium in the vanadium flow battery positive electrolyte calculated by:

> determining the ratio of excess absorbance for two pairs of specific wavelengths; and
> estimating the concentration of vanadium, $V^{IV}$ and/or $V^V$ by solving simultaneous equations based on the determined ratio of excess absorbance for the two pairs of specific wavelengths.

In one embodiment the equation for the simultaneous equations comprises

$$A_{y\,nm} \approx \frac{\delta^*_{y\,nm}(A_{x\,nm} - \epsilon^V_{x\,nm}([V^{IV}] + [V^{IV}])L)}{\delta^*_{x\,nm}} + \epsilon^{V^{IV}}_{y\,nm}[V^{IV}]L$$

where $A_{y\,nm}$ is absorbance at y nanometres and $A_{x\,nm}$ is the absorbance at x nanometres, $\delta$ is a constant that is dependent on the extinction coefficient and the concentration of the complex, $\epsilon^{V^{IV}}_\lambda$ and $\epsilon^{V^V}_\lambda$ are the extinction coefficients for the $V^{IV}$ and $V^V$ species, respectively, at the wavelength ($\lambda$) of interest, $[V^{IV}]$ and $[V^V]$ are the $V^{IV}$ and $V^V$ concentration, respectively, before the formation of a complex, and L is the pathlength of the light through the solution

In one embodiment the excess absorbance at a specific wavelength is determined by:

> measuring the absorbance at a specific wavelength of a solution of known vanadium concentration;
> calculating the predicted absorbance at the specific wavelength that would occur if no complexes were present; and
> subtracting this calculated predicted absorbance value from the measured absorbance value.

**Brief Description of the Drawings**

The invention will be more clearly understood from the following description of an embodiment thereof, given by way of example only, with reference to the accompanying drawings, in which:-

> Figure 1 shows an example of a method for determining state-of-charge (SoC) of a vanadium redox flow battery (VRFB);
> Figure 2 shows an example of a method for determining mixture ratio of the positive electrolyte facilitating the determination of the SoC of a VRFB;
> Figure 3 shows the absorption spectra at concentrations of 1.54 mol dm$^{-3}$, 0.77 mol dm$^{-3}$ and 0.15 mol dm$^{-3}$ for (a) $V^{II}$, (b) $V^{III}$, (c), $V^{IV}$ and (d) $V^V$ solutions. All solutions were prepared by charging or discharging, where necessary, from $VOSO_4$ solutions of the required concentration in supporting electrolytes of 3 mol dm$^{-3}$ $H_2SO_4$;
> Figure 4 (a) shows absorbance as a function of wavelength for mixtures of 1.5 mol dm$^{-3}$ $V^{II}$ and $V^{III}$ solutions shown in Figure 3 and (b) as a function of ratio of V" to overall vanadium;

Figure 5 shows graphs of the effect of dilution on absorbance values at 760 nm as a function of ratio of $V^V$ to overall vanadium. The overall vanadium concentration of the solutions are: (a) 1.24, (b) 0.77, (c) 0.30, and (d) 0.06 mol dm$^{-3}$. The original solution was prepared by charging the vanadium in a 1.55 mol dm$^{-3}$ VOSO$_4$ solution in a supporting electrolyte of 3 mol dm$^{-3}$ H$_2$SO$_4$ to the $V^V$ state;

Figure 6 shows the absorbance, predicted absorbance and the difference between the two (i.e. excess absorbance) (a) as a function of wavelength and (b) as a function of ratio of $V^V$ to overall vanadium for mixtures of $V^{IV}$ and $V^V$ solutions shown in Figure 5;

Figure 7 shows graphs that allow the experimental (dots) and predicted (line) absorbance as a function of percentage $V^V$ at (a) 760 nm, (b) 670 nm, (c) 521 nm, and (d) 450 nm to be compared (for the same mixtures as in Figure 6);

Figure 8 shows the absorption spectra for different mixtures of $V^{IV}$ and $V^V$ solutions of 1.24 mol dm$^{-3}$ vanadium, as shown in Figure 6. The mixtures shown are for $V^V$ of approximately 0, 10, 30, 51, 66, 89 and 100% of total vanadium;

Figure 9 (a) shows a graph of excess absorbance value as a function of wavelength for the different mixtures of 1.24 mol dm$^{-3}$ vanadium solutions similar to those shown in Figure 8, while Figure 9 (b) shows a graph of the ratio of excess absorbance at 760 or 450 nm to that at 520 nm as a function of percentage $V^V$. Triangles and circles represent $A^*$(760 nm)/$A^*$(520 nm) and $A^*$(450 nm)/$A^*$(520 nm), respectively. Overall vanadium concentrations of 1.55, 1.24, 0.77 and 0.30 mol dm$^{-3}$ are represented by black, blue, red and green symbols, respectively; and

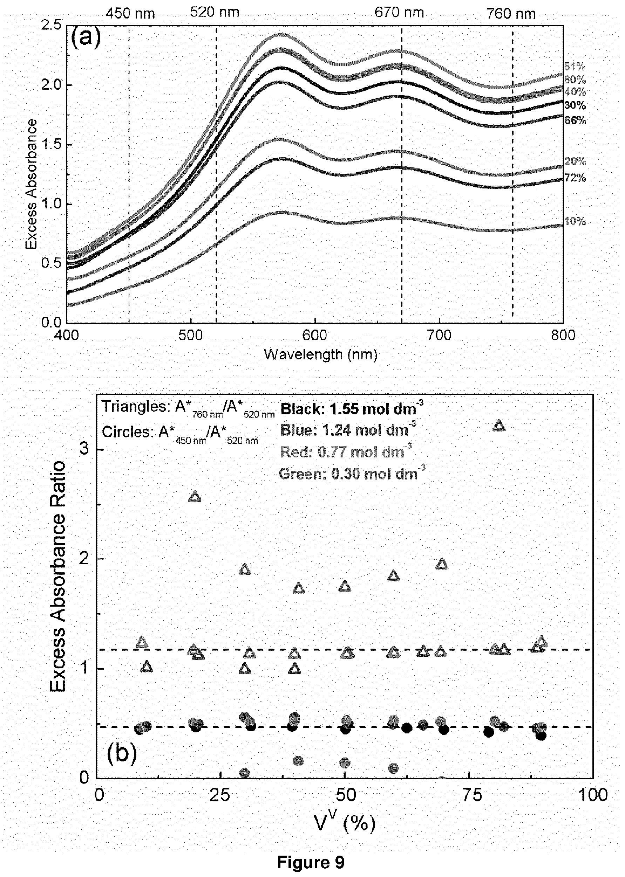

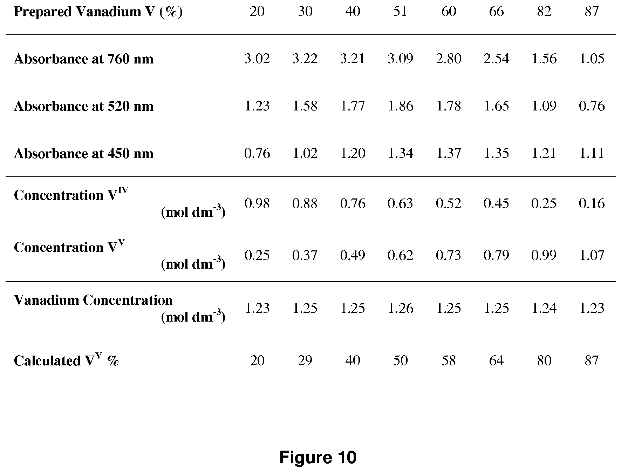

Figure 10 is a table showing a comparison of the prepared and estimated (via absorption spectroscopy) $V^V$ percentages for 1.24 mol dm$^{-3}$ mixtures using equations similar to Eq. (4) set out in the specification. The $A^*_{760\,nm}/A^*_{520\,nm}$ and $A^*_{450\,nm}/A^*_{520\,nm}$ values are taken from Figure 9b to be 1.09 and 0.50, respectively. The extinction coefficients $\epsilon^V_{520\,nm} = 0.52$ mol dm$^{-3}$ cm$^{-1}$, $\epsilon^{V^{IV}}_{760\,nm} = 17.8$ mol dm$^{-3}$ cm$^{-1}$ and $\epsilon^{V^V}_{450\,nm} = 7.04$ mol dm$^{-3}$ cm$^{-1}$ were calculated from $V^{IV}$ and $V^V$ spectra and the pathlength (L) was 0.1 cm.

## Detailed Description of the Drawings

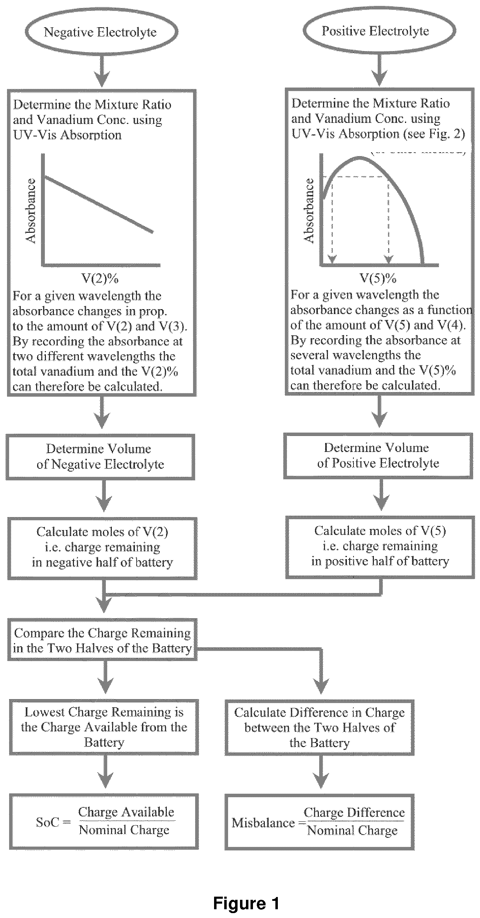

The present invention describes a sequence of methods to determine the amount of vanadium species in the charged state, i.e. the concentration of V" and $V^V$ in $V^{II}$/$V^{III}$ and $V^{IV}$/$V^V$ mixed solutions, respectively. These methods allow the state of charge (SoC) of both the positive and negative half-cells of a vanadium redox flow cell (VRFC) to be calculated, which in turn enables the SoC of the VRFC, as well as the imbalance in the state of the two half-cells to be determined, as shown in Figure 1.

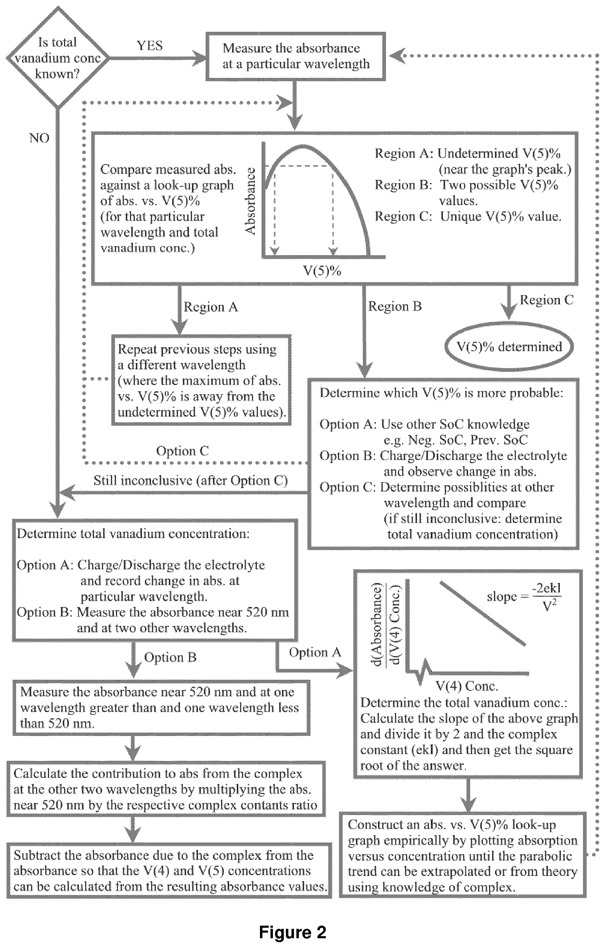

More particularly, the methods of the present invention enable the accurate measurement of the fraction of vanadium in the $V^V$ state (positive electrolyte state-of-charge) in mixtures of $V^{IV}$ and $V^V$ solutions (i.e. the positive electrolyte or catholyte), see Figure 2, thus overcoming the problem of there being a non-linear relationship between absorbance and $V^V$ fraction for the positive electrolyte in vanadium solutions. Once the measurement of the $V^V$ fraction in $V^{IV}$/$V^V$ solutions has been obtained by means of the methods of the present invention, the results can be combined with standard spectroscopic methods or alternative methods (such as those described in the background to the invention section) for measuring the fraction of vanadium in the V" state (negative electrolyte state-of-charge) in the negative electrolyte (i.e. $V^{II}$/$V^{III}$ mixtures). This in turn enables the SoC and other parameters of VRFBs and other batteries and devices that use mixtures of $V^{IV}$ and $V^V$ solutions to be determined.

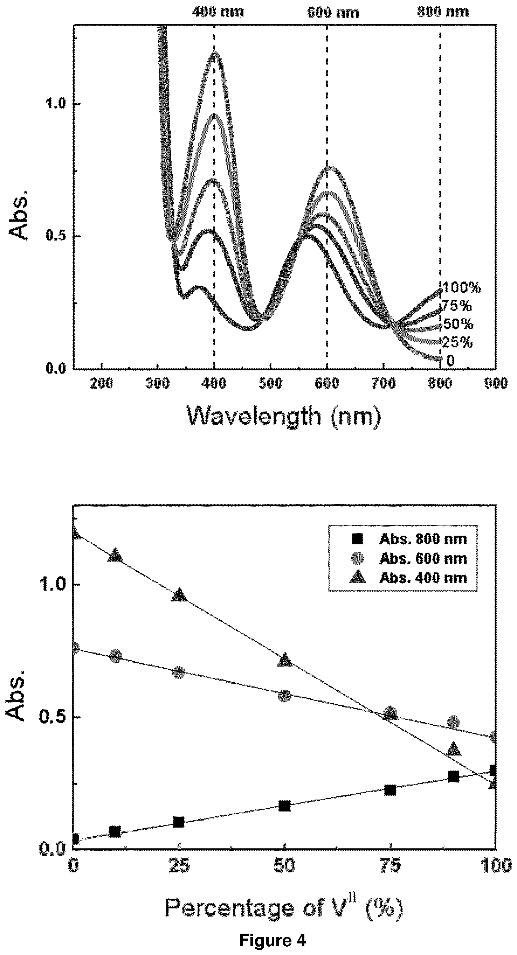

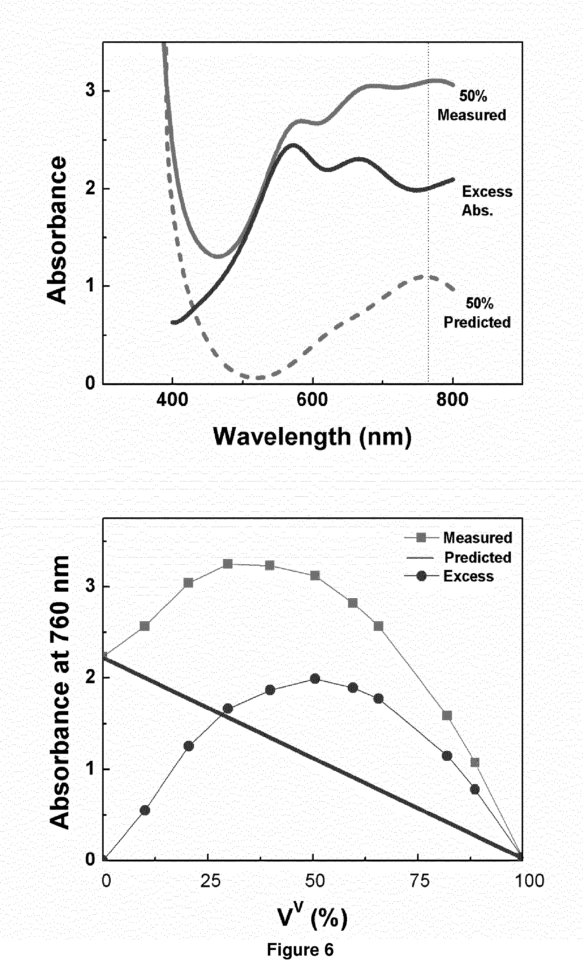

As shown in Figure 3 the four vanadium species - i.e. the four vanadium oxidation states that exist in solution: $V^{II}$, $V^{III}$, $V^{IV}$ and $V^V$ - have significantly different absorption spectra. In a solution that contains a mixture of two of these vanadium species the absorption spectrum is composed of components due to the two respective species. Therefore as long as the species do not interact to form complexes the mixture's spectrum should be simply the addition of the absorbance due to each species. This is the case for $V^{II}$/$V^{III}$ (as shown in Figure 4), $V^{III}$/$V^{IV}$ and dilute $V^{IV}$/$V^V$ mixtures (as shown in Figure 5d). However, for $V^{IV}$/$V^V$ mixtures of the concentrations used in VRFBs the absorbance values are the sum of three absorbance components, i.e. , as shown in Figure 6, the components due to absorbance by $V^{IV}$ and $V^V$ species and the absorbance due to a complex of the two species. It follows that for solutions of increasing overall vanadium concentration the relationship between absorbance and fraction of $V^V$ goes from being linear to being parabolic, as shown in Figure 5. Unfortunately the concentration of the complex is never significant enough to allow it to be determined making it non straight-forward to determine the fraction of $V^V$ in a concentrated vanadium solution from the absorbance.

Figure 2 shows a method for determining the fraction of $V^V$ and hence to determine the SoC of the positive electrolyte: If the overall concentration of the vanadium in the solution is known the absorbance can be measured at a particular wavelength and compared to a look-up graph of absorbance versus fraction of $V^V$ (for that wavelength), as shown for 760 nm in Figure 6b. The look-up graph can be compiled empirically by measuring the absorbance of several solutions of known mixture ratio and the same overall vanadium concentration and then by fitting a quadratic curve to the resulting set of data (which is usually a parabolic curve in cases where the ratio of the concentration of the complex to the product of the concentrations of $V^{IV}$ and $V^V$ is very small). Alternatively, the graph can be constructed from theory and calibrated using a $V^{IV}$ solution of known concentration (which may not necessarily be the same as the solution to be examined) and one solution of known mixture ratio and the same overall vanadium concentration as the electrolyte that is being examined.

There are three valid results, as shown in Figure 2, for the comparison of the absorbance of the positive electrolyte to its respective look-up graph:

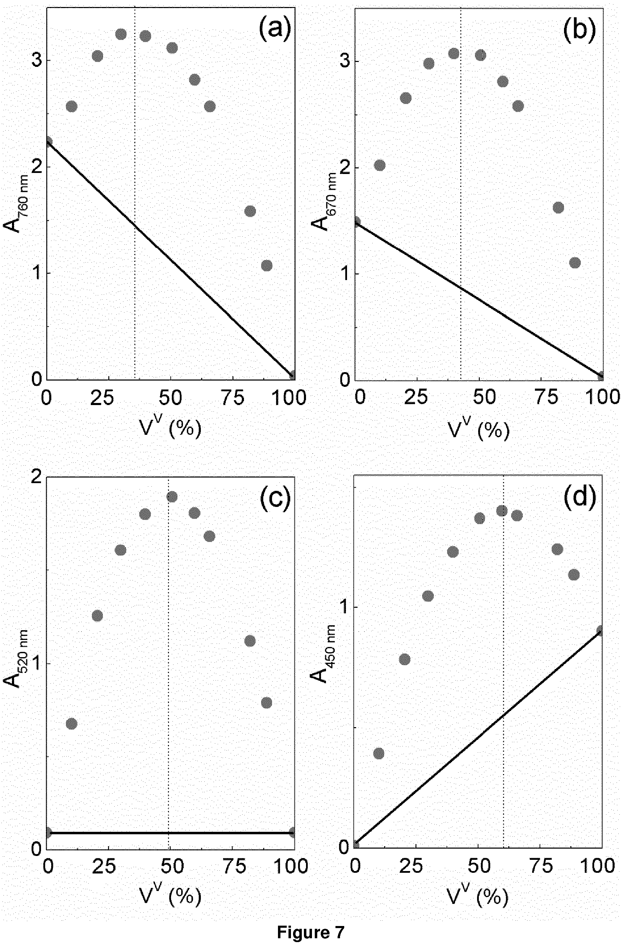

1. In a first case, the absorbance of the electrolyte could be close to the maximum, resulting in a wide range of possible values for the fraction of $V^V$, *i.e.* an inaccurate result. In such cases the absorbance at a second wavelength (the maximum absorbance value of which occurs outside the range of possible values for fraction of $V^V$), as shown in Figure 7, can be examined;

2. In a second case, due to the quadratic dependence of absorbance on the fraction of $V^V$, the measured absorbance of the electrolyte can be attributed to solutions of two different mixture ratios. Such a case can be solved by looking at the absorbance at a second wavelength. At the second wavelength up to two possible $V^V$ fractions will be given as possibilities. However, only one of these possibilities will agree with the possible $V^V$ fractions that could result in the absorbance at the first wavelength tested. Furthermore, instead of looking at the absorbance at a second wavelength other options; such as using previous knowledge of positive SoC, negative SoC or cell voltage or monitoring of change in absorbance with charging or discharging of the electrolyte; can indicate which of the results for $V^V$ fraction is valid; or

3. In a third case, the absorbance measured at the first wavelength could have given a unique result therefore allowing the positive SoC to be determined from the absorbance at one wavelength.

Since the absorbance at each wavelength will give one, two or a range of results, several wavelengths can be used to determine the accuracy of the result or the need to recalibrate the system.

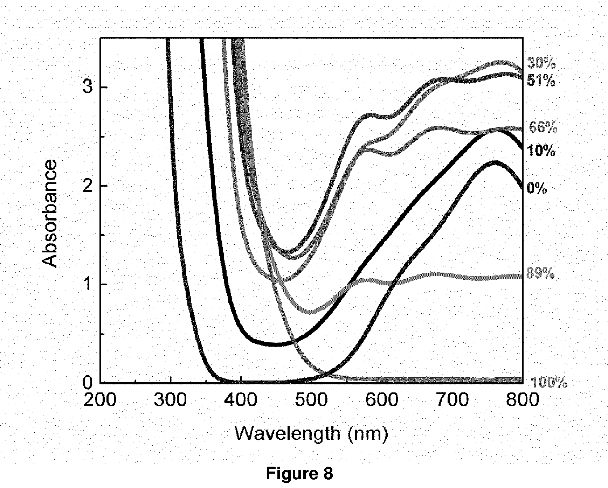

In cases, where the overall vanadium concentration is unknown or it is decided to verify or calibrate the system knowledge about the complex can facilitate the determination of vanadium concentration and determination of $V^V$ fraction. For example, the absorbance for $V^{IV}$ and $V^V$ near 520 nm is almost the same and almost zero (see Figure 8), *i.e.* there is an isosbestic point near this wavelength where both $V^{IV}$ and $V^V$ have the same low molar absorptivity. Therefore the vast majority of the absorbance at this wavelength for mixtures of $V^{IV}$ and $V^V$ at VRFB vanadium concentrations, as shown in Figures 7c and 8 is due to absorbance by the complex. Furthermore the excess absorbance caused by the presence of the complex (see Figure 9) at any other wavelength can be calculated by multiplying the excess absorbance at 520 nm by a characteristic constant. The ratio of the excess absorbance at any two wavelengths is a constant for concentrations of 0.7 mol dm$^{-3}$ or greater, independent of mixture ratio and total vanadium concentration as shown in Figure 9b. The method allows the concentration of $V^{IV}$ and $V^V$ to be calculated separately and therefore the overall vanadium concentration and mixture ratio of the solution can be calculated without prior knowledge of the vanadium concentration. Therefore the excess absorbance at any wavelength can be calculated from the excess absorbance near 520 nm and therefore the absorbance due to just the $V^{IV}$ and $V^V$ species can be found. It follows that mixture ratio and overall vanadium concentration can be calculated.

Figure 9a shows the excess absorbance values for 1.24 mol dm$^{-3}$ mixtures as a function of wavelength. It can be observed that the ratio of excess absorbance at any two different wavelengths is almost constant (*i.e.* independent of mixture ratio). For instance, as shown in Figure 9b, for 1.24 mol dm$^{-3}$ mixture (blue), $A^*_{450\,nm}/A^*_{521\,nm}$ (circles) is ~0.5 and $A^*_{760\,nm}/A^*_{521\,nm}$ (triangles) is ~1.1 (where $A^*_{\lambda}$ is the excess absorbance value). Using the same method to analyse solutions of different overall vanadium concentration, it is found that, for 1.55 mol dm$^{-3}$ (black) and 0.77 mol dm$^{-3}$ (red) mixtures, these two ratios ( $A^*_{450\,nm}/A^*_{521\,nm}$ and $A^*_{760\,nm}/A^*_{521\,nm.}$ ) are almost the same as the values calculated for the 1.24 mol dm$^{-3}$ mixtures. However, it is also found that for the 0.30 mol dm$^{-3}$ solution (green), these two ratios vary as mixture ratio changes. Therefore, for 0.77 mol dm$^{-3}$ and above the ratios of excess absorbance are independent of both concentration and mixture ratio.

Using the following derivation, the mixture ratio and the concentrations of $V^{IV}$ or $V^V$ can be determined using the excess absorbance ratios. As an example, we will look at the values of absorbance for 1.24 mol dm$^{-3}$ mixtures. Firstly, the excess absorbance can be calculated by subtracting the sum of $V^{IV}$ and $V^V$ absorbance values from the absorbance values for the solution at a given wavelength (as shown for each wavelength between 400 and 800 nm in Figure 8a): *i.e.*

$$A_\lambda^* = A_\lambda - \epsilon_\lambda^{V^{IV}}[V^{IV}]L - \epsilon_\lambda^{V^{V}}[V^{V}]L \qquad (1)$$

where $[V^{IV}]$ and $[V^{V}]$ are the $V^{IV}$ and $V^{V}$ concentration, respectively, before the formation of a complex, L is the pathlength of the light through the solution, and $\epsilon_\lambda^{V^{IV}}$ and $\epsilon_\lambda^{V^{V}}$ are the extinction coefficients for the $V^{IV}$ and $V^{V}$ species, respectively, at the wavelength ($\lambda$) of interest

Since the extinction coefficient at 760 nm due to $V^{V}$, $\epsilon_{760\,nm}^{V^{V}}$, is almost zero, the absorbance at 760 nm for the mixture is mainly composed of the excess absorbance and $V^{IV}$ absorbance. It follows from Eq. (1) that:

$$A_{760\,nm} \approx \delta_{760\,nm}^* L + \epsilon_{760\,nm}^{V^{IV}}[V^{IV}]L \qquad (2)$$

where $\delta_{760\,nm}^*$ is a constant that is dependent on the extinction coefficient and the concentration of the complex.

Similarly, since at the isosbestic (crossover) point of the $V^{IV}$ and $V^{V}$ spectra (near 520 m) both $\epsilon_{520\,nm}^{V^{IV}}$ and $\epsilon_{520\,nm}^{V^{V}}$ are almost the same, the variation of absorbance at 520 nm as a function of the fraction of $V^{V}$ is solely due to the variation in complex concentration (for constant overall vanadium concentration). It follows from Eq. (1) that:

$$A_{520\,nm} \approx \delta_{520\,nm}^* L + \epsilon_{520\,nm}^{V}([V^{IV}] + [V^{IV}])L \qquad (3)$$

where $\delta_{520\,nm}^*$ is similar and directly proportional to the respective constant in Eq. (2) but for 520 nm and $\epsilon_{520\,nm}^{V}$ is the extinction coefficient of $V^{IV}$ and $V^{V}$ at 520 nm. It should be noted that the extinction coefficient of the complex and the concentration of the complex is difficult to determine and the equilibrium constant $K$ for the formation of the complex, where $[complex] = K [V^{IV}]_{eq} [V^{V}]_{eq}$, is unknown. However, equations 2 and 3 can be combined as:

$$A_{760\,nm} \approx \frac{\delta_{760\,nm}^*(A_{520\,nm} - \epsilon_{520\,nm}^{V}([V^{IV}] + [V^{IV}])L)}{\delta_{520\,nm}^*} + \epsilon_{760\,nm}^{V^{IV}}[V^{IV}]L \qquad (4)$$

where $\delta_{760\,nm}^*/\delta_{520\,nm}^*$ is equal to $\frac{A_{760\,nm}^*}{A_{520\,nm}^*}$. In a similar manner an equation for the absorbance at 450 nm can be derived with respect to $[V^{V}]$. (Furthermore, the absorbance at any number of couples of wavelengths can be chosen to derive similar equations.) It follows that by measuring the absorbance at three wavelengths, two equations with two unknowns, $[V^{IV}]$ and $[V^{V}]$, can be formed and therefore solved, as shown in Figure 10.

Figure 10 shows the calculated species concentrations for solutions of different mixture ratio, but the same overall vanadium concentration (1.24 mol dm$^{-3}$). Using the absorbance values shown for $V^{IV}/V^{V}$ mixtures in Figure 8 the fraction of $V^{V}$ ($[V^{V}]/([V^{IV}] + [V^{V}])$) along with the overall vanadium concentration were calculated. The method can achieve very good estimates for both the mixture ratio and overall vanadium concentration.

This technique can be used in conjunction with other methods for determining the $V^{IV}$, $V^{V}$ or total vanadium concentration allowing these three concentrations to be estimated from the absorbance at two or more wavelengths. Furthermore, wavelengths other than the three chosen here can be used.

Alternatively, overall vanadium concentration can be determined from observing the change in absorbance at any wavelength (or several wavelengths) while charging or discharging the electrolyte (or an aliquot of the electrolyte). This technique also relies on the excess absorbance being dependent on a characteristic constant $(B = \epsilon_\lambda^* KL)$ for each wavelength. It follows that the absorbance at wavelengths greater than 520 nm, e.g. at 760 nm can be written as

$$A_{760\,nm} = -B\left(\frac{[V^{IV}]}{[V]}\right)^2 + B\left(\frac{[V^{IV}]}{[V]}\right) + C\frac{[V^{IV}]}{[V]} + D \qquad (5)$$

Where B, C and D are constants. Therefore the change in absorbance with charge or $V^{IV}$ concentration can be written as

$$\frac{dA_{760\,nm}}{d[V^{IV}]} = -\frac{2B}{[V]^2}[V^{IV}] + \frac{B+C}{[V]} \qquad (6)$$

This results in a straight-line graph when $\frac{dA_{760\,nm}}{dV^{IV}}$ is plotted against $V^{IV}$ concentration or change in $V^{IV}$ concentration. The slope of the graph is $-\frac{2B}{[V]^2}$ and therefore the total vanadium concentration can be calculated during a short charge/discharge of a known volume of positive electrolyte. Once this has been determined the $V^V$ fraction (*i.e.* the SoC) of the positive electrolyte can then be determined, as explained earlier (see Figure 2) or by imputing the $V^{IV}$ or $V^V$ concentration into Eq. (4) or a similar equation.

Alternative mathematical manipulation of the quadratic relationship between the concentration of the complex (*i.e.* the excess absorbance due to the complex) and the concentration of $V^{IV}$ or $V^V$ in mixture solutions other than those shown here can also be used to achieve values for the concentrations of $V^{IV}$ and/or $V^V$ from the absorbance at one or more wavelengths. Furthermore, in conjunction with part or all of one of the techniques previously described the $V^{IV}$ or $V^V$ concentration or the $V^{IV}$ or $V^V$ fraction estimated from the manipulation of the quadratic relationship can be used to find the concentrations of $V^{IV}$, $V^V$ and total vanadium.

In addition these techniques can be extended to analytical devices that use optical characteristics of vanadium solutions other than transmittance and absorbance, such as reflection, refraction, total internal reflection etc.

It will be appreciated that the above described methods have a number of advantages over the prior art methods of determining the mixture ratio of vanadium solutions. Firstly, they allow the mixture ratios and hence state of charge of the two half cells to be measured independently of each other and independently of the electrochemistry of the system. In addition they allow the mixture ratio of the respective electrolyte to be measured *in situ* and both the vanadium concentration and the mixture ratio to be determined, which is very important in real systems. This is because it is important to not have to rely on the original vanadium concentration, as the volume (and therefore the concentration) of the electrolyte can vary due to evaporation of solution from the system, or transfer of solution species across the membrane. Indeed, the transfer of solution species can also result in the total number of moles of vanadium (and therefore the concentration) changing in the reservoirs during experiments.

The embodiments in the invention described with reference to the drawings comprise of look-up charts and calculations. However, the invention also extends to computer apparatus and/or processes performed in a computer apparatus, computer programs, particularly computer programs stored on or in a carrier adapted to bring the invention into practice. The program may be in the form of source code, object code, or a code intermediate source and object code, such as in partially compiled form or in any other form suitable for use in the implementation of the method according to the invention. The carrier may comprise a storage medium such as ROM, *e.g.* CD ROM, or magnetic recording medium, *e.g.* a floppy disk or hard disk. The carrier may be an electrical or optical signal which may be transmitted via an electrical or an optical cable or by radio or other means.

In the specification the terms "comprise, comprises, comprised and comprising" or any variation thereof and the terms include, includes, included and including" or any variation thereof are considered to be totally interchangeable and they should all be afforded the widest possible interpretation and *vice versa*.

**Claims**

1.  A method for determining the state of charge, SoC, of a vanadium flow battery positive electrolyte comprising a solution of $V^{IV}$ and/or $V^V$, the method comprising the steps of:

   determining the absorbance of the solution at at least one wavelength; and
   calculating the concentration of $V^{IV}$ and/or $V^V$ in the vanadium flow battery positive electrolyte based on the absorbance.

2.  The method of Claim 1, wherein the overall vanadium concentration in the vanadium flow battery positive electrolyte is known and where a non-proportional relationship exists between the vanadium species concentration and absorbance due to the presence of complexes between $V^{IV}$ and $V^V$, wherein the step of calculating the concentration of $V^{IV}$ and/or $V^V$ in the vanadium flow battery positive electrolyte based on the absorbance comprises the steps of:

comparing the absorbance against a look-up graph of absorbance versus fraction of Vv for at least one wavelength and for the same overall vanadium concentration; and

estimating the fraction of $V^{IV}$ and/or $V^V$ in the solution from the comparison.

3. The method of Claim 2 further comprising:

determining the absorbance of the solution of the vanadium flow battery positive electrolyte at at least one alternative wavelength;

comparing the absorbance against a look-up graph of absorbance versus fraction of $V^V$ for the at least one alternative wavelength and for the same overall vanadium concentration; and

estimating the fraction of $V^{IV}$ and/or $V^V$ in the solution from the comparison performed at the at least one wavelength and the comparison performed at the at least one alternative wavelength.

4. The method of Claim 2 further comprising estimating the fraction of $V^{IV}$ and/or $V^V$ in the solution from the comparison performed at the at least one wavelength and based on one or more of: positive state of charge, SoC, negative SoC, cell voltage or the change in absorbance when charging or discharging of the vanadium flow battery positive electrolyte.

5. The method of any of Claims 2 to 4, wherein the look-up graph of absorbance versus fraction of $V^V$ for a given wavelength is constructed by the steps of:

determining for the given wavelength the absorbance of a $V^{IV}$ solution of a known concentration; and

determining for the given wavelength the absorbance of a calibration sample of vanadium flow battery positive electrolyte of a known mixture ratio and a known vanadium concentration.

6. The method of Claim 5, wherein two calibration samples of vanadium flow battery positive electrolytes of known vanadium concentration and mixture ratio are used for the construction of the look-up graph.

7. The method of Claim 1, wherein the overall vanadium concentration is known and where a non-proportional relationship exists between vanadium species concentration and absorbance due to the presence of complexes between $V^{IV}$ and $V^V$, wherein the step of calculating the concentration of $V^{IV}$ and/or $V^V$ in the vanadium flow battery positive electrolyte based on the absorbance comprises the steps of:

determining the ratio of excess absorbance for a pair of specific wavelengths; and

estimating the concentration of $V^{IV}$ and/or $V^V$ by solving simultaneous equations based on the determined ratio of excess absorbance for the pair of specific wavelengths.

8. The method of Claim 1, wherein the total vanadium concentration is not known for the vanadium flow battery positive electrolyte and, wherein the total concentration of vanadium in the vanadium flow battery positive electrolyte is calculated by:

determining the ratio of excess absorbance for two pairs of specific wavelengths; and

estimating the concentration of vanadium, $V^{IV}$ and/or $V^V$ by solving simultaneous equations based on the determined ratio of excess absorbance for the two pairs of specific wavelengths.

9. The method of Claim 7 or Claim 8, wherein the equation for the simultaneous equations comprises

$$A_{y\,nm} \approx \frac{\delta^*_{y\,nm}(A_{x\,nm} - \epsilon^V_{x\,nm}([V^{IV}] + [V^V])L)}{\delta^*_{x\,nm}} + \epsilon^{V^{IV}}_{y\,nm}[V^{IV}]L$$

where $A_{y\,nm}$ is absorbance at y nanometres and $A_{x\,nm}$ is the absorbance at x nanometres, $\delta$ is a constant that is dependent on the extinction coefficient and the concentration of the complex, $\epsilon^{V^{IV}}_\lambda$ and $\epsilon^{V^V}_\lambda$ are the extinction coefficients for the $V^{IV}$ and $V^V$ species, respectively, at the wavelength ($\lambda$) of interest, $[V^{IV}]$ and $[V^V]$ are the $V^{IV}$ and $V^V$ concentration, respectively, before the formation of a complex, and L is the pathlength of the light through the solution.

**10.** The method of any of Claims 7 to 9, wherein the excess absorbance at a specific wavelength is determined by:

measuring the absorbance at a specific wavelength of a solution of known vanadium concentration;
calculating the predicted absorbance at the specific wavelength that would occur if no complexes were present; and
subtracting this calculated predicted absorbance value from the measured absorbance value.

**Patentansprüche**

**1.** Verfahren zum Bestimmen des Ladungszustands (state of charge, SoC) eines positiven Elektrolyts einer Vanadium-Flussbatterie umfassend eine Lösung von $V^{IV}$ und/oder $V^V$, wobei das Verfahren die folgenden Schritte umfasst:

Bestimmen der Absorbanz der Lösung bei zumindest einer Wellenlänge; und
Berechnen der Konzentration von $V^{IV}$ und/oder $V^V$ im positiven Elektrolyt der Vanadium-Flussbatterie auf der Basis der Absorbanz.

**2.** Verfahren nach Anspruch 1, wobei die allgemeine Vanadium-Konzentration im positiven Elektrolyt der Vanadium-Flussbatterie bekannt ist und wo eine nicht-proportionale Beziehung zwischen der Konzentration der Vanadium-Spezies und der Absorbanz infolge des Vorhandenseins von Komplexen zwischen $V^{IV}$ und $V^V$ besteht, wobei der Schritt des Berechnens der Konzentration von $V^{IV}$ und/oder $V^V$ im positiven Elektrolyt der Vanadium-Flussbatterie auf der Basis der Absorbanz die folgenden Schritte umfasst:

Vergleichen der Absorbanz mit einem Referenzdiagramm der Absorbanz über dem Anteil von $V^V$ für zumindest eine Wellenlänge und für dieselbe allgemeine Vanadium-Konzentration; und
Abschätzen des Anteils von $V^{IV}$ und/oder $V^V$ in der Lösung aus dem Vergleich.

**3.** Verfahren nach Anspruch 2, weiterhin umfassend:

Bestimmen der Absorbanz der Lösung des positiven Elektrolyts der Vanadium-Flussbatterie bei zumindest einer alternativen Wellenlänge;
Vergleichen der Absorbanz mit einem Referenzdiagramm der Absorbanz über dem Anteil von $V^V$ für die zumindest eine alternative Wellenlänge und für dieselbe allgemeine Vanadium-Konzentration; und
Abschätzen des Anteils von $V^{IV}$ und/oder $V^V$ in der Lösung aus dem bei der zumindest einen Wellenlänge durchgeführten Vergleich und dem bei der zumindest einen alternativen Wellenlänge durchgeführten Vergleich.

**4.** Verfahren nach Anspruch 2, weiterhin umfassend Abschätzen des Anteils von $V^{IV}$ und/oder $V^V$ in der Lösung aus dem bei der zumindest einen Wellenlänge durchgeführten Vergleich und auf der Basis von einem oder mehreren von: positivem Ladungszustand, SoC, negativem SoC, Zellspannung oder der Änderung in der Absorbanz während des Ladens oder Entladens des positiven Elektrolyts der Vanadium-Flussbatterie.

**5.** Verfahren nach einem der Ansprüche 2 bis 4, wobei das Referenzdiagramm der Absorbanz über dem Anteil von $V^V$ für eine gegebene Wellenlänge mit den folgenden Schritten konstruiert wird:

Bestimmen für die gegebene Wellenlänge der Absorbanz einer $V^{IV}$-Lösung einer bekannten Konzentration; und
Bestimmen für die gegebene Wellenlänge der Absorbanz einer Eichprobe von positivem Elektrolyt einer Vanadium-Flussbatterie mit einem bekannten Mischungsverhältnis und einer bekannten Vanadium-Konzentration.

**6.** Verfahren nach Anspruch 5, wobei zwei Eichproben von positivem Elektrolyt einer Vanadium-Flussbatterie mit bekannter Vanadium-Konzentration und bekanntem Mischungsverhältnis für die Konstruktion des Referenzdiagramms benutzt werden.

**7.** Verfahren nach Anspruch 1, wobei die allgemeine Vanadium-Konzentration bekannt ist und wo eine nicht-proportionale Beziehung zwischen Konzentration der Vanadium-Spezies und Absorbanz infolge des Vorhandenseins von Komplexen zwischen $V^{IV}$ und $V^V$ besteht, wobei der Schritt des Berechnens der Konzentration von $V^{IV}$ und/oder $V^V$ im positiven Elektrolyt der Vanadium-Flussbatterie auf der Basis der Absorbanz die folgenden Schritte umfasst:

Bestimmen des Verhältnisses von Überschuss-Absorbanz für ein Paar von spezifischen Wellenlängen; und

Abschätzen der Konzentration von $V^{IV}$ und/oder $V^V$ durch Lösen von simultanen Gleichungen auf der Basis des bestimmten Verhältnisses von Überschuss-Absorbanz für das Paar von spezifischen Wellenlängen.

8. Verfahren nach Anspruch 1, wobei die gesamte Vanadium-Konzentration für das positive Elektrolyt der Vanadium-Flussbatterie nicht bekannt ist und wobei die gesamte Vanadium-Konzentration im positiven Elektrolyt der Vanadium-Flussbatterie folgendermaßen berechnet wird:

Bestimmen des Verhältnisses von Überschuss-Absorbanz für zwei Paare von spezifischen Wellenlängen; und Abschätzen der Konzentration von Vanadium, $V^{IV}$ und/oder $V^V$ durch Lösen von simultanen Gleichungen auf der Basis des bestimmten Verhältnisses von Überschuss-Absorbanz für die zwei Paare von spezifischen Wellenlängen.

9. Verfahren nach Anspruch 7 oder 8, wobei die Gleichung für die simultanen Gleichungen umfasst:

$$A_{y\,nm} \approx \frac{\delta^*_{y\,nm}(A_{x\,nm} - \epsilon^V_{x\,nm}([V^{IV}] + [V^V])L)}{\delta^*_{x\,nm}} + \epsilon^{V^{IV}}_{y\,nm}[V^{IV}]L$$

wobei $A_{y\,nm}$ die Absorbanz bei y Nanometer ist und $A_{x\,nm}$ die Absorbanz bei x Nanometer ist, $\delta$ eine Konstante ist, die von dem Extinktionskoeffizienten und der Konzentration des Komplexes abhängt, $\epsilon_\lambda^{V^{IV}}$ und $\epsilon_\lambda^{V^V}$ die Extinktionskoeffizienten jeweils für die $V^{IV}$- und $V^V$-Spezies bei der Wellenlänge ($\lambda$) von Interesse sind, $[V^{IV}]$ und $[V^V]$ jeweils die $V^{IV}$- und $V^V$-Konzentration vor der Bildung eines Komplexes sind, und L die Weglänge des Lichts durch die Lösung ist.

10. Verfahren nach einem der Ansprüche 7 bis 9, wobei die Überschuss-Absorbanz bei einer spezifischen Wellenlänge folgendermaßen bestimmt wird:

Messen der Absorbanz bei einer spezifischen Wellenlänge einer Lösung mit bekannter Vanadium-Konzentration;
Berechnen der vorhergesagten Absorbanz bei der spezifischen Wellenlänge, die auftreten würde, wenn keine Komplexe vorhanden wären; und
Subtrahieren dieses berechneten vorhergesagten Absorbanzwertes von dem gemessenen Absorbanzwert.

## Revendications

1. Procédé de détermination de l'état de charge, SoC, d'un électrolyte positif de batterie à flux au vanadium comprenant une solution de $V^{IV}$ et/ou $V^V$, le procédé comprenant les étapes de :

détermination de l'absorbance de la solution à au moins une longueur d'onde ; et
calcul de la concentration de $V^{IV}$ et/ou $V^V$ dans l'électrolyte positif de batterie à flux au vanadium en fonction de l'absorbance.

2. Procédé selon la revendication 1, dans lequel la concentration de vanadium totale dans l'électrolyte positif de batterie à flux au vanadium est connue et une relation non proportionnelle existe entre la concentration d'espèces de vanadium et l'absorbance en raison de la présence de complexes entre $V^{IV}$ et $V^V$, dans lequel l'étape de calcul de la concentration de $V^{IV}$ et/ou $V^V$ dans l'électrolyte positif de batterie à flux au vanadium en fonction de l'absorbance comprend les étapes de :

comparaison de l'absorbance à un graphe de consultation d'absorbance par rapport à une fraction de $V^V$ pour au moins une longueur d'onde et pour la même concentration de vanadium totale ; et
estimation de la fraction de $V^{IV}$ et/ou $V^V$ dans la solution à partir de la comparaison.

3. Procédé selon la revendication 2 comprenant en outre :

la détermination de l'absorbance de la solution de l'électrolyte positif de batterie à flux au vanadium à au moins une autre longueur d'onde ;

la comparaison de l'absorbance à un graphe de consultation d'absorbance par rapport à une fraction de $V^V$ pour l'au moins une autre longueur d'onde et pour la même concentration de vanadium totale ; et

l'estimation de la fraction de $V^{IV}$ et/ou $V^V$ dans la solution à partir de la comparaison réalisée à l'au moins une longueur d'onde et de la comparaison réalisée à l'au moins une autre longueur d'onde.

4. Procédé selon la revendication 2 comprenant en outre l'estimation de la fraction de $V^{IV}$ et/ou $V^V$ dans la solution à partir de la comparaison réalisée à l'au moins une longueur d'onde et en fonction d'un ou plusieurs des éléments suivants : un état de charge SoC positif, un SoC négatif, une tension de cellule ou le changement d'absorbance lors de la charge ou de la décharge de l'électrolyte positif de batterie à flux au vanadium.

5. Procédé selon l'une quelconque des revendications 2 à 4, dans lequel le graphe de consultation d'absorbance par rapport à une fraction de $V^V$ pour une longueur d'onde de données est construit par les étapes de :

détermination pour la longueur d'onde donnée de l'absorbance d'une solution de $V^{IV}$ d'une concentration connue ; et

détermination pour la longueur d'onde donnée de l'absorbance d'un échantillon d'étalonnage d'électrolyte positif de batterie à flux au vanadium d'un rapport de mélange connu et d'une concentration de vanadium connue.

6. Procédé selon la revendication 5, dans lequel deux échantillons d'étalonnage d'électrolyte positif de batterie à flux au vanadium de concentration de vanadium et rapport de mélange connus sont utilisés pour la construction du graphe de consultation.

7. Procédé selon la revendication 1, dans lequel la concentration de vanadium totale est connue et une relation non proportionnelle existe entre la concentration d'espèces de vanadium et l'absorbance en raison de la présence de complexes entre $V^{IV}$ et $V^V$, dans lequel l'étape de calcul de la concentration de $V^{IV}$ et/ou $V^V$ dans l'électrolyte positif de batterie à flux au vanadium en fonction de l'absorbance comprend les étapes de :

détermination du rapport d'excès d'absorbance pour une paire de longueurs d'onde spécifique ; et

estimation de la concentration de $V^{IV}$ et/ou $V^V$ en résolvant des équations simultanées en fonction du rapport déterminé d'excès d'absorbance pour la paire de longueurs d'onde spécifique.

8. Procédé selon la revendication 1, dans lequel la concentration de vanadium totale n'est pas connue pour l'électrolyte positif de batterie à flux au vanadium et, dans lequel la concentration totale de vanadium dans l'électrolyte positif de batterie à flux au vanadium est calculée en :

déterminant le rapport d'excès d'absorbance pour deux paires de longueurs d'onde spécifiques ; et

estimant la concentration de vanadium, $V^{IV}$ et/ou $V^V$ en résolvant des équations simultanées basées sur le rapport déterminé d'excès d'absorbance pour les deux paires de longueurs d'onde spécifiques.

9. Procédé selon la revendication 7 ou la revendication 8, dans lequel l'équation pour les équations simultanées comprend

$$A_{y\,nm} \approx \frac{\delta_{y\,nm}^*(A_{x\,nm} - \epsilon_{x\,nm}^V([V^{IV}] + [V^V])L)}{\delta_{x\,nm}^*} + \epsilon_{y\,nm}^{V^{IV}}[V^{IV}]L$$

où $A_{y\,nm}$ est l'absorbance à y nanomètres et $A_{x\,nm}$ est l'absorbance à x nanomètres, $\delta$ est une constante qui dépend du coefficient d'extinction et de la concentration du complexe, $\epsilon_\lambda^{V^{IV}}$ et $\epsilon_\lambda^{V^V}$ sont les coefficients d'extinction pour les espèces $V^{IV}$ et $V^V$, respectivement, à la longueur d'onde ($\lambda$) d'intérêt, $[V^{IV}]$ et $[V^V]$ sont les concentrations de $V^{IV}$ et $V^V$, respectivement, avant la formation d'un complexe, et L est la longueur du trajet de la lumière à travers la solution.

10. Procédé selon l'une quelconque des revendications 7 à 9, dans lequel l'excès d'absorbance à une longueur d'onde spécifique est déterminé en :

mesurant l'absorbance à une longueur d'onde spécifique d'une solution de concentration de vanadium connue ;
calculant l'absorbance prédite à la longueur d'onde spécifique qui se produirait si aucun complexe n'était présent ; et
soustrayant cette valeur d'absorbance prédite calculée de la valeur d'absorbance mesurée.

**Figure 1**

Is total vanadium conc. known?

YES → Measure the absorbance at a particular wavelength

NO

Compare measured abs. against a look-up graph of abs. vs. V(5)% (for that particular wavelength and total vanadium conc.)

Absorbance / V(5)%

Region A: Undetermined V(5)% (near the graph's peak.)
Region B: Two possible V(5)% values.
Region C: Unique V(5)% value.

Region A

Region B

Region C

Repeat previous steps using a different wavelength (where the maximum of abs. vs. V(5)% is away from the undetermined V(5)% values).

Option C

V(5)% determined

Determine which V(5)% is more probable:

Option A: Use other SoC knowledge e.g. Neg. SoC, Prev. SoC
Option B: Charge/Discharge the electrolyte and observe change in abs.
Option C: Determine possiblities at other wavelength and compare (if still inconclusive: determine total vanadium concentration)

Still inconclusive (after Option C)

Determine total vanadium concentration:

Option A: Charge/Discharge the electrolyte and record change in abs. at particular wavelength.
Option B: Measure the absorbance near 520 nm and at two other wavelengths.

Option B

Option A

$$\text{slope} = \frac{-2ekl}{V^2}$$

d(Absorbance) / d(V(4) Conc.) vs. V(4) Conc.

Determine the total vanadium conc.: Calculate the slope of the above graph and divide it by 2 and the complex constant (ekl) and then get the square root of the answer.

Measure the absorbance near 520 nm and at one wavelength greater than and one wavelength less than 520 nm.

Calculate the contribution to abs from the complex at the other two wavelengths by multiplying the abs. near 520 nm by the respective complex contants ratio

Subtract the absorbance due to the complex from the absorbance so that the V(4) and V(5) concentrations can be calculated from the resulting absorbance values.

Construct an abs. vs. V(5)% look-up graph empirically by plotting absorption versus concentration until the parabolic trend can be extrapolated or from theory using knowledge of complex.

**Figure 2**

**Figure 3**

Figure 4

**Figure 5**

Figure 6

Figure 7

**Figure 8**

Figure 9

| Prepared Vanadium V (%) | | 20 | 30 | 40 | 51 | 60 | 66 | 82 | 87 |
|---|---|---|---|---|---|---|---|---|---|
| Absorbance at 760 nm | | 3.02 | 3.22 | 3.21 | 3.09 | 2.80 | 2.54 | 1.56 | 1.05 |
| Absorbance at 520 nm | | 1.23 | 1.58 | 1.77 | 1.86 | 1.78 | 1.65 | 1.09 | 0.76 |
| Absorbance at 450 nm | | 0.76 | 1.02 | 1.20 | 1.34 | 1.37 | 1.35 | 1.21 | 1.11 |
| Concentration $V^{IV}$ | (mol dm$^{-3}$) | 0.98 | 0.88 | 0.76 | 0.63 | 0.52 | 0.45 | 0.25 | 0.16 |
| Concentration $V^{V}$ | (mol dm$^{-3}$) | 0.25 | 0.37 | 0.49 | 0.62 | 0.73 | 0.79 | 0.99 | 1.07 |
| Vanadium Concentration | (mol dm$^{-3}$) | 1.23 | 1.25 | 1.25 | 1.26 | 1.25 | 1.25 | 1.24 | 1.23 |
| Calculated $V^{V}$ % | | 20 | 29 | 40 | 50 | 58 | 64 | 80 | 87 |

**Figure 10**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012022535 A
- WO 9003666 A
- US 7855005 B, Sahu
- CN 102539362

**Non-patent literature cited in the description**

- **ZHIJIANG TANG et al.** *ECS Transactions,* 01 January 2012, vol. 41 (23), 1-9
- **L. LIE et al.** *J. Appl. Electrochem.,* 2012, vol. 42, 1025